(19) Europäisches Patentamt
European Patent Office
Office européen des brevets

(11) **EP 2 190 020 B1**

(12) **FASCICULE DE BREVET EUROPEEN**

(45) Date de publication et mention
de la délivrance du brevet:
**25.07.2012 Bulletin 2012/30**

(51) Int Cl.:
***H01L 27/146*** *(2006.01)*

(21) Numéro de dépôt: **09306103.4**

(22) Date de dépôt: **17.11.2009**

(54) **Procédé d'amincissement d'un bloc reporté sur un substrat**

Verfahren zur Verdünnung eines Blocks, der auf ein Substrat aufgebracht ist

Method for planing down a block added to a substrate

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **20.11.2008 FR 0857897**

(43) Date de publication de la demande:
**26.05.2010 Bulletin 2010/21**

(73) Titulaire: **Commissariat à l'Énergie Atomique et aux Énergies Alternatives
75015 Paris (FR)**

(72) Inventeur: **Marion, François
38950, SAINT MARTIN LE VINOUX (FR)**

(74) Mandataire: **Vuillermoz, Bruno et al
Cabinet Laurent & Charras
"Le Contemporain"
50, Chemin de la Bruyère
69574 Dardilly Cédex (FR)**

(56) Documents cités:
**EP-A- 0 224 699       EP-A- 1 548 836
US-A- 5 264 395       US-A- 5 646 053
US-A1- 2007 259 463**

## Description

### DOMAINE DE L'INVENTION

L'invention a trait au domaine de la fabrication de composants microélectroniques, et plus particulièrement à l'amincissement de composants microélectroniques rapportés sur un substrat.

### ETAT DE LA TECHNIQUE

Dans certains détecteurs matriciels, la fonction de détection du rayonnement électromagnétique est réalisée par une matrice d'éléments sensibles rapportés sur un substrat comprenant l'ensemble de la circuiterie de lecture desdits éléments. Parmi de tels détecteurs, on peut par exemple citer ceux éclairés par la face arrière ou encore, ceux mettant en oeuvre des bolomètres à membrane suspendue. De tels détecteurs sont usuellement conçus par hybridation, par exemple au moyen de techniques de « flip-chip », d'hybridation par collage simple ou par insertion.

Les composants ainsi reportés sur le substrat sont ensuite amincis afin de réaliser leur fonction de détection.

Les techniques d'amincissement mécanique de l'état de la technique, comme par exemple le polissage ou le rodage, permettent d'obtenir des épaisseurs finales d'environ 20 micromètres avec une bonne précision. Ces techniques consistent généralement à répéter des cycles d'amincissement du matériau sur une épaisseur donnée, suivi du contrôle de l'amincissement réellement produit. Toutefois, l'obtention d'épaisseurs inférieures à 20 micromètre nécessite un nombre important de tels cycles, ainsi qu'un parallélisme très précis des amincissements successifs. Généralement, il est considéré que l'amincissement mécanique ne donne pas de bons résultats lorsqu'une épaisseur résiduelle inférieure à 20 micromètres est souhaitée.

Il existe également des techniques d'amincissement par attaque chimique, mettant en oeuvre des couches d'arrêt. Lors de la fabrication des composants microélectroniques à amincir, il est inséré dans chacun de ceux-ci une couche dite d'« arrêt ». Cette couche d'arrêt, insensible à l'attaque chimique utilisée pour amincir les composants, permet ainsi un contrôle efficace de l'amincissement. Toutefois l'introduction d'une couche d'arrêt à l'intérieur même des composants à amincir nécessite une fabrication plus complexe et coûteuse de ceux-ci. Il est par exemple nécessaire de prévoir des étapes de dépôts spécifiques sous ultravide lorsque les composants comprennent des composés II-VI ou III-V, de fabrication de couche d'arrêt en $SiO_2$ pour des composants en silicium, ou encore l'introduction de couches spécifiques dopées en profondeur.

Le document US 5, 264, 395 décrit un exemple de procédé d'amincissement.

### EXPOSE DE L'INVENTION

Le but de la présente invention est de résoudre les problèmes susmentionnés en proposant un procédé d'amincissement de composants reportés sur un substrat, qui permette d'obtenir des épaisseurs résiduelles très faibles avec une grande précision, sans que cela induise une complexité de fabrication des composants à amincir ou un coût élevé.

A cet effet, l'invention a pour objet un procédé d'amincissement d'un bloc reporté sur un substrat, qui, selon l'invention, comporte :

■ le dépôt, au moins sur le substrat et de manière adjacente et contiguë audit bloc reporté, d'une couche d'arrêt réalisée en un matériau de plus grande résistance ou dureté que le matériau constitutif du bloc reporté à amincir et d'épaisseur plus faible que celle dudit bloc reporté;
■ le déclenchement de l'amincissement du bloc reporté.

Selon l'invention, la couche d'arrêt peut être déposée par électrolyse ou par dépôt électrolytique ou par dépôt simple, tel que évaporation, pulvérisation, dépôt chimique en phase vapeur : CVD (« *Chemical Vapor Deposition* »), voire torche plasma.

Selon l'invention, la réalisation de la couche d'arrêt peut comporter le dépôt d'une couche de germe par pulvérisation ou évaporation sur le substrat, suivi du dépôt par électrolyse sur la couche de germe d'une couche de croissance en matériau de plus grande résistance ou dureté que celle dudit bloc reporté.

Le bloc reporté à amincir est par exemple réalisé en silicium, et le matériau de plus grande résistance ou dureté de la couche d'arrêt est un métal dur, notamment du chrome, du nickel ou du cuivre, ou un alliage de ceux-ci.

Avantageusement, la couche d'arrêt peut comporter à sa surface supérieure une couche en diamant, en carbure de silicium ou en alumine.

L'amincissement peut être réalisé par polissage ou par rodage.

Selon l'invention, la durée de l'amincissement est préprogrammée en fonction d'une vitesse d'amincissement prédéterminée du bloc reporté, la durée de l'amincissement étant sélectionnée pour que l'amincissement attaque également partiellement la couche d'arrêt.

Selon un mode de réalisation de l'invention, la couche d'arrêt est également déposée sur la face supérieure du bloc reporté, le procédé comportant en outre retrait de la portion de couche d'arrêt déposée sur la face supérieure du bloc reporté préalablement au déclenchement de l'amincissement du bloc reporté.

Selon une version de l'invention, le bloc reporté est enrobé préalablement au dépôt de la couche d'arrêt.

Selon un autre mode de réalisation de l'invention, le bloc reporté appartient à une matrice de blocs reportés sur le substrat, la couche d'arrêt étant déposée au moins entre les blocs de la matrice et l'amincissement étant réalisé collectivement sur l'ensemble des blocs de la matrice.

## BREVE DESCRIPTION DES FIGURES

L'invention sera mieux comprise à la lecture de la description qui va suivre, donnée uniquement à titre d'exemple, et réalisée en relation avec les dessins annexés, dans lesquels des références identiques désignent des éléments identiques ou analogues, et dans lesquels :

-   les figures 1 à 4 illustrent le principe général du procédé selon l'invention ; et
-   les figures 5 à 13 illustrent un procédé de fabrication d'un détecteur matriciel à retro éclairage selon l'invention.

## DESCRIPTION DETAILLEE DE L'INVENTION

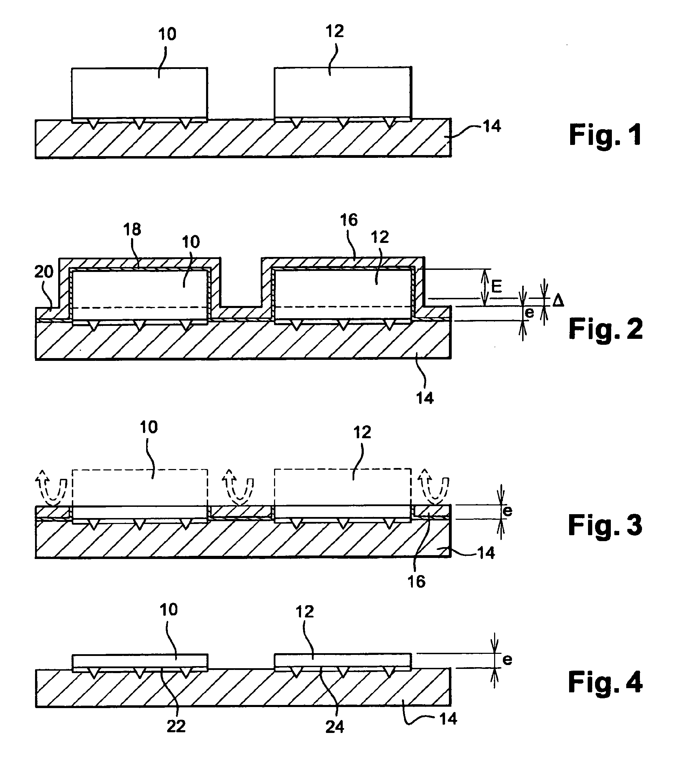

Sur la figure 1, des blocs de silicium **10, 12** sont reportés sur un substrat **14,** par exemple par la technologie « flip-chip », par un collage simple, ou par insertion de pointes après un pré-enrobage comme décrit dans la demande WO-A-2006 054005, ou toute autre technique permettant d'hybrider ensemble deux ensembles hétérogènes.

Le procédé d'amincissement selon l'invention débute par le dépôt d'une couche d'arrêt **16** sur la face supérieure de l'ensemble hybridé, de manière à recouvrir les blocs reportés **10, 12** et le substrat **14** (figure 2). La couche d'arrêt **16** présente une dureté supérieure à celle du matériau constituant les blocs **10, 12,** et une épaisseur e inférieure à celle des blocs **10, 12.**

Le dépôt de la couche d'arrêt **16** est classiquement réalisé par électrolyse ou dépôt électrolytique selon des techniques connues. Par exemple, la couche d'arrêt **16** est obtenue par dépôt d'une première couche de germe **18** (plus connue sous l'expression anglo-saxonne « *seed layer* »), suivi du dépôt d'une couche de croissance **20** par électrolyse.

La couche de germe **18** est réalisée en deux phases. Un premier dépôt d'une couche d'accroche en titane, en chrome ou en tungstène est dans un premier temps réalisé par pulvérisation ou évaporation, puis une couche de métal, tel que de l'or, du cuivre, du platine, ou du nickel (ou tout autre matériau propice à l'électrolyse) est déposé sur la couche d'accroche.

La couche de croissance **20** est quant à elle déposée sur la couche de germe **18** par électrolyse, et est constituée d'un matériau électrolysable plus dur que celui constituant les blocs **10, 12.** Lorsque ces derniers sont constitués de silicium, la couche de croissance **20** est préférentiellement constituée de chrome, de nickel ou de cuivre.

Le dépôt de la couche d'arrêt **16** peut également être obtenu au moyen d'un dépôt simple, par exemple au moyen d'une évaporation, un dépôt chimique en phase vapeur, un dépôt chimique en phase vapeur assisté par plasma, une pulvérisation ou toute technique de dépôt classique sur semi-conducteur.

Le dépôt de la couche d'arrêt **16** peut également être réalisé par une combinaison de ces techniques. Par exemple, la couche **16** est obtenue par un premier dépôt électrolytique d'un métal épais de dureté moyenne, suivi par un second dépôt simple d'une couche très dure comme du diamant, du carbure de silicium ou de l'alumine par exemple.

Une fois la couche d'arrêt **16** déposée, le procédé selon l'invention se poursuit par l'amincissement des blocs reportés **10, 12** (figure 3).

Une technique d'amincissement mécanique, comme par exemple un rodage ou un polissage, est mise en oeuvre.

Une fois la portion de la couche d'arrêt **16** ôtée de la face supérieure des blocs **10, 12,** l'amincissement se poursuit dans l'épaisseur de ceux-ci. L'amincissement présente alors une vitesse de progression définie par la dureté du matériau constitutif des blocs.

Une fois que l'amincissement atteint la face supérieure de la couche d'arrêt **16** déposée sur le substrat de manière adjacente et contigüe au bloc **10, 12,** la dureté de la couche d'arrêt **16** induit une chute de la vitesse d'amincissement et l'amincissement est alors stoppé. L'épaisseur résiduelle des blocs **10, 12** est ainsi, dans cet exemple qui n'est pas selon l'invention, sensiblement égale à l'épaisseur e de la couche d'arrêt **16.**

L'arrêt de l'amincissement est préprogrammé. Par exemple, lorsque l'amincissement est réalisé mécaniquement à l'aide d'un dispositif de polissage qui comprend une brosse entraînée en rotation par un moteur électrique, on connaît la vitesse d'amincissement en fonction de la nature des matériaux à amincir et des réglages du dispositif de polissage. Ainsi, par exemple pour un réglage particulier de celui-ci, la vitesse « $V_{si}$ » d'amincissement du silicium constitutif des blocs **10, 12** est connue, de même que la vitesse « $V_{Cr}$ » d'amincissement de la couche d'arrêt **16.**

Dans un premier temps, le dispositif de polissage est programmé pour qu'il fonctionne pendant N minutes avec $N = \dfrac{E - \Delta}{V_{si}}$,

où :

■ E est l'épaisseur à ôter des blocs **10, 12,**
■ et $\Delta$ est une épaisseur prédéterminée très inférieure à E (voir figure 2).

Une fois ce premier amincissement terminé, l'épaisseur résiduelle des blocs **10, 12** est alors proche de l'épaisseur de la couche d'arrêt **16.**

Dans un second temps, on programme le dispositif avec les mêmes réglages pour qu'il fonctionne pendant M minutes avec $M = \dfrac{\Delta + \delta}{V_{Si}}$, expression dans laquelle $\delta$ désigne une épaisseur prédéterminée très inférieure à $\Delta$. Le dispositif de polissage retire ainsi l'épaisseur $\Delta$ des blocs **10, 12** et attaque la couche d'arrêt **16.**

Du fait de la différence de dureté entre le matériau constitutifs des blocs **10, 12** et celui de la couche d'arrêt **16,** ce n'est pas une épaisseur $\delta$ supplémentaire qui va être retirée des blocs **10, 12** pendant les M minutes de polissage, mais une épaisseur $\varepsilon = \delta \times \dfrac{V_{Cr}}{V_{Si}}$ du fait que le dispositif attaque également la couche d'arrêt **16.**

De préférence, la couche d'arrêt est attaquée sur toute son épaisseur.

L'intérêt de programmer une durée correspondant à une épaisseur supérieure à $\Delta$ réside dans le fait que la surface supérieure des blocs **10, 12** va subir un polissage uniforme, les rendant sensiblement lisses.

La précision de l'épaisseur finalement obtenue dépend donc du paramètre $\delta$ et de la sélectivité de l'amincissement caractérisé par le rapport $\dfrac{V_{Si}}{V_{Cr}}$. a sélectivité $\dfrac{V_{Si}}{V_{Cr}}$ de l'amincissement est réglée par le choix du ou des matériaux constitutifs de la couche d'arrêt **16.** Par exemple avec des blocs **10, 12** en silicium et une couche d'arrêt **16** en chrome, la sélectivité $\dfrac{V_{Si}}{V_{Cr}}$ est sensiblement égale à 10. En ajoutant une pellicule de diamant, de carbure de silicium ou d'alumine à la surface de la couche d'arrêt **16,** la sélectivité passe alors à 100.

Ainsi en considérant qu'un dispositif de polissage de l'état de la technique permet une précision d'amincissement de $\underline{p}$ micromètre lorsqu'il est utilisé seul, cette précision passe à $p \times \dfrac{V_{Cr}}{V_{Si}}$ grâce à l'utilisation de la couche d'arrêt **16.** Un gain de précision de dix, voire de cent, est ainsi obtenu tout en garantissant des surfaces très lisses des blocs amincis.

A titre d'exemple numérique, des blocs d'une épaisseur de 510 micromètres sont reportés par hybridation sur un substrat au moyen de billes de soudure d'une épaisseur de 10 micromètres. Les blocs reportés forment des circuits de détection CMOS, et sont donc principalement constitués de Si, le substrat comportant quant à lui les circuits de lecture des circuits de détection (lecture proprement dite, compression, conversion analogique/numérique, etc...). Il est souhaité obtenir des blocs reportés d'une épaisseur de 10 micromètres.

Après un éventuel enrobage des blocs reportés, une couche d'arrêt est déposée sur l'ensemble :

■ en réalisant le dépôt pleine plaque d'une couche de germe métallique par pulvérisation ou évaporation, cette couche de germe métallique étant constituée :

- d'une première couche d'accroche de 50 nanomètres par exemple en Ti (ou en Cr, W ou tout autre métal connu pour ses propriétés de couche d'accroche) ;
- d'une seconde couche de métal, déposée sur la couche d'accroche, d'une épaisseur de 100 nanomètres, par exemple en Au (ou en Cu, Pt, Ni ou tout autre métal propice à une électrolyse).

■ en formant la couche ayant la fonction d'arrêt proprement dite par électrolyse d'un métal dur. Par exemple, cette couche est formée de Cr (ou de Ni, de Cu ou de tout autre métal qui présente à la fois la propriété d'être facilement électrolysable et d'être plus dur que le matériau constitutif des blocs reportés, ici le silicium). Par exemple, une électrolyse de 19850 nanomètres de ce métal est réalisée sur la couche de germe métallique.

L'épaisseur totale de métal pour la couche d'arrêt ainsi obtenue est donc de 20 micromètres (50 nanomètres de couche en Ti + 100 nanomètres de couche en Au + 19850 nanomètres de couche en Cr).

L'épaisseur résiduelle visée pour les blocs reportés est donc bien de 10 micromètres compte tenu de l'épaisseur des billes de soudure de 10 micromètres.

La plaque ainsi obtenue est alors fixée sur un support et amincie à l'aide d'un processus mécanique ou un processus chimique connus de l'état de la technique.

En choisissant par exemple une vitesse d'amincissement par polissage du silicium des blocs reportés de 50 micromètres/mn et sachant par ailleurs qu'en appliquant les mêmes réglages de polissage à une couche d'arrêt en chrome, on obtient une vitesse d'amincissement de 5 micromètres/mn $\left( \dfrac{V_{Si}}{V_{Cr}} = 10 \right)$, on applique :

■ une première durée d'amincissement choisie pour ôter 90% de l'épaisseur totale que l'on souhaite retirer aux blocs reportés (soit 90% de 500 micromètres, sachant que les blocs reportés ont une épaisseur de 510 micromètres et qu'on désire une épaisseur résiduelle de 10 micromètres), soit une durée de polissage choisie pour ôter 450 micromètres. La première durée de polissage programmée est ainsi égale à 450/Vsi=450/50=9mn. A la fin de ce premier amincissement, les blocs reportés ont une épaisseur de 50 micromètres, leur surface étant ainsi à une hauteur de 70 micromètres de la surface du substrat compte tenu de l'épaisseur des billes de soudure de 10 micromètres ;

■ une seconde durée de polissage, le polissage étant programmé avec les mêmes réglages que le polissage appliqué lors de la première durée. Cette seconde durée est choisie 10% supérieure à la durée nécessaire pour ôter les 50 micromètres restants à ôter des blocs reportés, c'est-à-dire une seconde durée égale à 110% de 50/Vsi=50/50=1nm, soit 1,1 mn.

Comme cela a été précédemment indiqué, du fait de la dureté 10 fois supérieure du Cr par rapport à celle du Si, le polissage s'arrête en réalité à une altitude proche des 20 micromètres de la surface du substrat.

En fait, la « surattaque » induite par les 10% supplémentaire de durée ne va ôter que 1 micromètre de silicium supplémentaire. La couche de chrome joue donc bien son rôle de couche d'arrêt tout en obtenant une uniformisation de l'amincissement sur toute la surface des blocs reportés sur le substrat. La valeur critique de l'épaisseur finale est donc atteinte de manière aisée.

Le retrait de la couche d'arrêt est obtenu de manière connue en soi, les chimies d'attaque du chrome (ou de nickel, de cuivre, etc.) étant classiques.

On notera qu'un amincissement par attaque chimique peut également être programmé selon le même principe.

De même, une détection active de la chute de la vitesse d'amincissement peut également être mise en oeuvre. Par exemple, le moteur électrique du dispositif de polissage est commandé en couple au moyen d'un courant d'alimentation. Lorsque la brosse du dispositif rencontre la couche d'arrêt 16 plus dure, le courant d'alimentation est augmenté de manière significative afin de conserver le couple constant. Cette augmentation de courant correspond alors à la chute de la vitesse d'amincissement et la détection de cette augmentation de courant est utilisée pour stopper l'amincissement.

Une fois l'amincissement terminé, la couche d'arrêt 16 est alors retirée (figure 4), par exemple en réalisant une attaque chimique de celle-ci, bien connue de l'homme du métier.

Préférentiellement, la couche d'arrêt 16 est sélectionnée afin d'être sensible à une attaque chimique sélective ne dégradant sensiblement pas les matériaux constitutifs des blocs 10, 12 et du substrat 14, ce qui est le cas lorsque les blocs 10, 12 sont en silicium et la couche d'arrêt 16 est réalisée en chrome, en nickel ou en cuivre.

On notera également que les blocs reportés 10, 12 jouent par ailleurs le rôle de masque vis-à-vis de l'attaque chimique utilisée pour retirer la couche d'arrêt 16, protégeant ainsi les portions de substrat situés sous eux. Dans le cas où un pré-enrobage des blocs 10, 12 a été réalisé préalablement au dépôt de la couche d'arrêt 16, la portion d'enrobage 22, 24 située entre les blocs 10, 12 et le substrat 14 (plus communément connue sous l'expression anglo-saxonne d'« underfill ») joue également ce rôle de masquage. Ce pré-enrobage peut être constitué d'une résine polymère (colle époxy, colle silicone, et est destiné à protéger et fiabiliser les composants, et plus précisément à assurer l'herméticité desdits composants, tout en réduisant les contraintes sur les éléments de liaison.

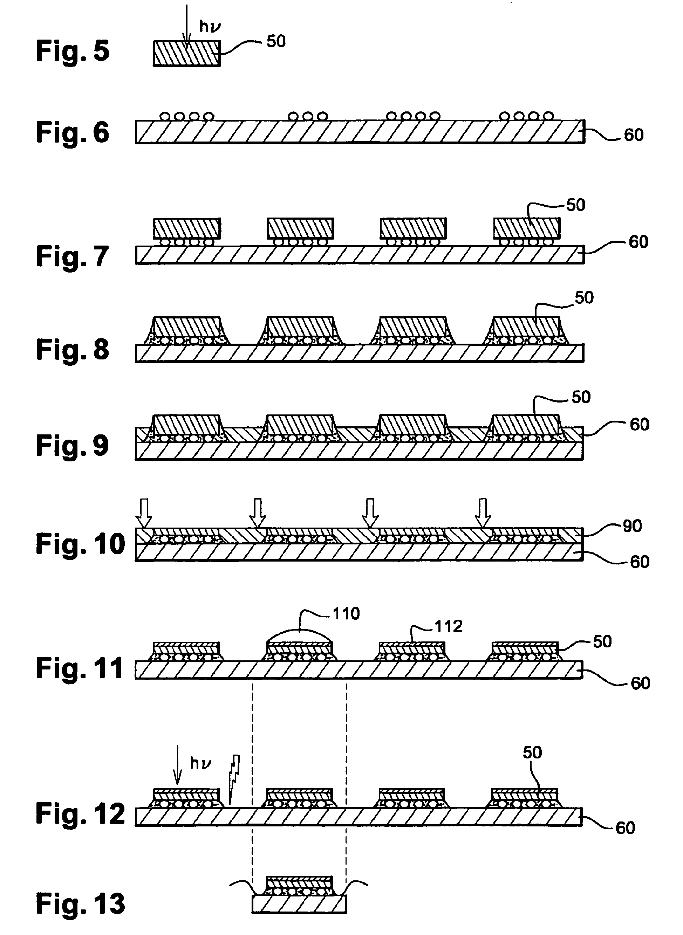

Les figures 5 à 13 illustrent un procédé de fabrication d'un détecteur matriciel à éclairage arrière, ou détecteur rétro éclairé, mettant en oeuvre le procédé d'amincissement selon l'invention.

Le procédé de fabrication débute (figure 5) par la réalisation d'un circuit 50 de détection en technologie CMOS, comportant une matrice de photodétecteurs élémentaires. Un circuit 60 de traitement du signal en technologie CMOS est également réalisé (figure 6) et intégré dans un substrat. Une hybridation du circuit de détection 50 et du circuit 60 de traitement du signal est alors réalisée (figure 7) de manière traditionnelle, par exemple par un collage, par une technique de « flip-chip », par une technique d'insertion de pointe, ou autres. Le procédé de fabrication se poursuit ensuite par l'enrobage des photodétecteurs élémentaires (figure 8). Ces étapes sont classiques et ne seront donc pas décrites plus en détail pour des raisons de concision.

Le procédé de fabrication se poursuit alors par l'amincissement des photodétecteurs tel que décrit précédemment, à savoir le dépôt d'une couche d'arrêt 90 (figure 9), préférentiellement uniquement entre les photodétecteurs, suivi d'un rodage ou d'un polissage (figure 10), l'amincissement se terminant lorsqu'une chute de la vitesse du rodage ou du polissage survient.

Le procédé de fabrication se poursuit alors par le retrait de la couche d'arrêt 90 par attaque chimique, et une étape dite de « post-processing » rendue possible par une épaisseur faible des photodétecteurs (figure 11). Cette étape consiste notamment en l'adjonction d'une microlentille 110 ou d'un filtre coloré 112 sur la face supérieure de chaque photodétecteur aminci, comme cela est connu en soi. En effet, avec une telle faible épaisseur des photodétecteurs, il est possible de réaliser les étapes technologiques suivantes, telle que la lithographie en vue de graver des filtres ou des réseaux, ce que n'autorise pas un photodétecteur d'épaisseur plus importante.

Après une étape de test électro-optique (figure 12), par exemple réalisée collectivement au moyen d'une carte à pointes agencée sous le circuit de traitement du signal, la plaque constituée des photodétecteurs 50 hybridés au circuit de traitement du signal 60 est découpée (figure 13) pour un assemblage des circuits imageurs élémentaires ainsi obtenus dans un boitier.

Grâce à l'invention, il est ainsi obtenu les avantages suivants :

■ un contrôle précis de l'amincissement ; une précision inférieure au micromètre est ainsi obtenue grâce à l'invention et des épaisseurs résiduelles inférieures à 10 micromètres sont réalisables ;

■ l'amincissement faible ainsi réalisé permet de continuer par un procédé de type semi-conducteur. En effet, dans l'état de la technique, pour procéder à des traitements ultérieurs tels que de la photolithographie, ou des dépôts, il est nécessaire de changer le support d'accueil de l'ensemble aminci en raison de l'épaisseur importante de celui-ci. Grâce aux épaisseurs très faibles obtenues par le procédé selon l'invention, il n'est plus besoin de changer de support. Un gain de temps et de matériel est ainsi réalisé ;

■ l'utilisation de la couche d'arrêt déposée sur le substrat joue également le rôle de couche de protection de celui-ci lors de l'amincissement. Dans l'état de la technique, une couche de protection est également nécessaire pour protéger le substrat lors de l'amincissement. De fait, le dépôt de la couche d'arrêt ne constitue pas une étape supplémentaire dans le processus de fabrication des composants micro électroniques hybridés amincis ;

■ le coût de l'amincissement selon l'invention est sensiblement réduit par rapport aux techniques utilisant l'incorporation d'une couche d'arrêt à l'intérieur même des blocs reportés à amincir.

## Revendications

1. Procédé d'amincissement d'un bloc (10, 12) reporté sur un substrat (14), comportant:

   ■ le dépôt, au moins sur le substrat (14) et de manière adjacente et contigüe au bloc reporté (10, 12), d'une couche d'arrêt (16) réalisée en un matériau de plus grande résistance ou dureté que le matériau constitutif du bloc reporté (10, 12) et d'épaisseur plus faible que celle dudit bloc reporté (10, 12) ;
   ■ le déclenchement de l'amincissement du bloc reporté (10, 12), la durée de l'amincissement étant préprogrammée en fonction d'une vitesse d'amincissement prédéterminée du bloc reporté (10, 12), la durée de l'amincissement étant sélectionnée pour que l'amincissement attaque également la couche d'arrêt (16) déposée sur le substrat et de manière adjacente et contigüe au bloc reporté (10, 12).

2. Procédé d'amincissement d'un bloc (10, 12) reporté sur un substrat (14) selon la revendication 1, *caractérisé* **en ce que** la couche d'arrêt (16) est déposée par voie électrolytique ou par dépôt simple, notamment par évaporation.

3. Procédé d'amincissement d'un bloc (10, 12) reporté sur un substrat (14) selon la revendication 1, *caractérisé* **en ce que** le dépôt de la couche d'arrêt (16) comporte le dépôt d'une couche de germe (18) par pulvérisation ou évaporation, suivi du dépôt par électrolyse sur la couche de germe (18) d'une couche de croissance (20) du matériau de plus grande résistance ou dureté que celle du matériau constitutif du bloc reporté (10, 12).

4. Procédé d'amincissement d'un bloc (10, 12) reporté sur un substrat (14) selon l'une quelconque des revendications précédentes, *caractérisé* **en ce que** le bloc reporté (10, 12) est réalisée en silicium, et **en ce que** le matériau de plus grande résistance ou dureté, constitutif de la couche d'arrêt est un métal dur, notamment du chrome, du nickel ou du cuivre, ou un alliage de ceux-ci.

5. Procédé d'amincissement d'un bloc (10, 12) reporté sur un substrat (14) selon l'une quelconque des revendications précédentes, *caractérisé* **en ce que** la couche d'arrêt (16) comporte à sa surface supérieure une couche réalisée en diamant, en carbure de silicium ou en alumine.

6. Procédé d'amincissement d'un bloc (10, 12) reporté sur un substrat (14) selon l'une quelconque des revendications précédentes, *caractérisé* **en ce que** l'amincissement est réalisé par polissage ou par rodage.

7. Procédé d'amincissement d'un bloc (10, 12) reporté sur un substrat (14) selon l'une quelconque des revendications précédentes, *caractérisé* **en ce que** l'amincissement est réglé pour obtenir une vitesse d'amincissement du bloc reporté sensiblement constante et est appliquée pendant N + M minutes, N et M étant des durées calculées selon les relations :

$$N = \frac{E - \Delta}{V_{Si}}$$

$$M = \frac{\Delta + \delta}{V_{Si}}$$

où $V_{Si}$ est la vitesse d'amincissement du bloc reporté, E est l'épaisseur à ôter du bloc reporté, $\Delta$ est une épaisseur prédéterminée très inférieure à E, et $\delta$ est une épaisseur très inférieure à $\Delta$.

8. Procédé d'amincissement d'un bloc (10, 12) reporté sur un substrat (14) selon l'une quelconques des revendications précédentes, *caractérisé* **en ce que** la couche d'arrêt (16) est également déposée sur la face supérieure du bloc reporté, et **en ce qu'**il comporte en outre le retrait de la portion de couche d'arrêt déposée sur la face supérieure du bloc reporté préalablement au déclenchement de l'amincissement du bloc reporté.

9. Procédé d'amincissement d'un bloc (10, 12) reporté sur un substrat (14) selon l'une quelconque des revendications précédentes, *caractérisé* **en ce qu'**un enrobage du bloc reporté est réalisé préalablement au dépôt de la couche d'arrêt (16).

10. Procédé d'amincissement d'un bloc (10, 12) reporté sur un substrat (14) selon l'une quelconque des revendications précédentes, *caractérisé* **en ce que** le bloc reporté appartient à une matrice de blocs reportés sur le substrat, la couche d'arrêt étant déposée au moins entre les blocs de la matrice, et l'amincissement étant réalisé collectivement sur l'ensemble des blocs de la matrice.

## Claims

1. A method of thinning a block (10, 12) transferred to a substrate (14), comprising:

   ■ depositing a stop layer (16) at least onto the substrate (14) and in a way adjacent to and contiguous with the transferred block (10, 12), said stop layer being made out of a material of greater resistance or hardness than the material constituting the transferred block (10, 12) and of smaller thickness than that of said transferred block (10, 12);
   ■ actuating the thinning of the transferred block (10, 12), the thinning time being pre-programmed as a function of a predetermined speed of thinning the transferred block (10, 12), the thinning time being selected so that the thinning also attacks the stop layer (16) deposited onto the substrate (14) and in a way adjacent to and contiguous with the transferred block (10, 12).

2. The method of thinning a block (10, 12) transferred to a substrate (14) as claimed in claim 1, **characterized in that** the stop layer (16) is deposited by electrolytic means or by straightforward deposition, and in particular by evaporation.

3. The method of thinning a block (10, 12) transferred to a substrate (14) as claimed in claim 1, **characterized in that** depositing the stop layer (16) comprises depositing a seed layer (18) by sputtering or evaporation, followed by the electrolytic deposition onto the seed layer (18) of a growth layer (20) of the material of greater resistance or hardness than that of the material constituting the transferred block (10, 12).

4. The method of thinning a block (10, 12) transferred onto a substrate (14) as claimed in any one of the previous claims, **characterized in that** the transferred block (10, 12) is made out of silicon, and **in that** the material of greater resistance or hardness, constituting the stop layer is a hard metal, and in particular chromium, nickel or copper, or an alloy thereof.

5. The method of thinning a block (10, 12) transferred to a substrate (14) as claimed in any one of the previous claims, **characterized in that** the stop layer (16) comprises on its upper surface a layer made of diamond, silicon carbide or alumina.

6. The method of thinning a block (10, 12) transferred onto a substrate (14) as claimed in any one of the previous claims, **characterized in that** the thinning is implemented by polishing or lapping.

7. The method of thinning a block (10, 12) transferred to a substrate (14) as claimed in any one of the previous claims, **characterized in that** the thinning is set in order to obtain a substantially constant speed of thinning the transferred block and is applied for N + M minutes, N and M being times calculated according to the relationships:

$$N = \frac{E - \Delta}{V_{Si}}$$

$$M = \frac{\Delta + \delta}{V_{Si}}$$

where $V_{Si}$ is the speed of thinning the transferred block, E is the thickness to be removed from the transferred block, $\Delta$ is a predetermined thickness much below E, and $\delta$ is a thickness much below $\Delta$.

8. The method of thinning a block (10, 12) transferred to a substrate (14) as claimed in any one of the previous claims, **characterized in that** the stop layer (16) is also deposited onto the upper face of the transferred block, and **in that** it further comprises removing the stop layer portion deposited onto the upper face of the transferred block prior to actuating the thinning of the transferred block.

9. The method of thinning a block (10, 12) transferred to a substrate (14) as claimed in any one of the previous claims, **characterized in that** the transferred block is imbedded prior to the deposition of the stop layer (16).

10. The method of thinning a block (10, 12) transferred to a substrate (14) as claimed in any one of the previous claims, **characterized in that** the transferred block belongs to a matrix of blocks transferred to the substrate, the stop layer being deposited at least between the blocks of the matrix, and the thinning being carried out collectively on all the blocks of the matrix.

**Patentansprüche**

1. Verfahren zum Abdünnen eines auf ein Substrat (14) aufgesetzten Blocks (10, 12), **dadurch gekennzeichnet, dass** es Folgendes umfasst:

   - zumindest auf das Substrat (14) angrenzend an und zusammenhängend mit dem aufgesetzten Block (10, 12) eine Blockierschicht (16) auftragen, die aus einem Material hergestellt ist, welches eine Festigkeit bzw. Härte, die größer ist als diejenige des Materials, aus dem der aufgesetzte Block (10, 12) besteht, und eine geringere Dicke als diejenige des aufgesetzten Blocks (10, 12) aufweist;
   - das Abdünnen des aufgesetzten Blocks (10, 12) auslösen, wobei die Dauer des Abdünnens in Abhängigkeit von einer vorgegebenen Geschwindigkeit des Abdünnens des aufgesetzten Blocks (10, 12) vorprogrammiert ist, wobei die Dauer des Abdünnens derart gewählt ist, dass die angrenzend an und zusammenhängend mit dem aufgesetzten Block (10, 12) auf das Substrat aufgetragene Blokkierschicht (16) mit abgedünnt wird.

2. Verfahren zum Abdünnen eines auf ein Substrat (14) aufgesetzten Blocks (10, 12) nach Anspruch 1, **dadurch gekennzeichnet, dass** die Blockierschicht (16) elektrolytisch oder durch einfaches Auftragen, insbesondere durch Verdampfung aufgetragen ist.

3. Verfahren zum Abdünnen eines auf ein Substrat (14) aufgesetzten Blocks (10, 12) nach Anspruch 1, **dadurch gekennzeichnet, dass** das Auftragen der Blockierschicht (16) das Auftragen einer Keimschicht (18) durch Sputtern oder Verdampfung und das anschließende elektrolytische Auftragen einer Wachstumsschicht (20) aus dem Material umfasst, das eine größere Festigkeit bzw. Härte aufweist als das Material, aus dem der aufgesetzte Block (10, 12) besteht.

4. Verfahren zum Abdünnen eines auf ein Substrat (14) aufgesetzten Blocks (10, 12) nach einem beliebigen der vorhergehenden Ansprüche, **dadurch gekennzeichnet, dass** der aufgesetzte Block (10, 12) aus Silizium hergestellt ist und dass das festere bzw. härtere Material, aus dem die Blockierschicht besteht, ein hartes Metall, insbesondere Chrom, Nickel oder Kupfer, oder eine daraus hergestellte Legierung ist.

5. Verfahren zum Abdünnen eines auf ein Substrat (14) aufgesetzten Blocks (10, 12) nach einem beliebigen der vorhergehenden Ansprüche, **dadurch gekennzeichnet, dass** die Blockierschicht (16) auf ihrer oberen Fläche eine Schicht aus Diamant, Siliziumkarbid oder Aluminiumoxid aufweist.

6. Verfahren zum Abdünnen eines auf ein Substrat (14) aufgesetzten Blocks (10, 12) nach einem beliebigen der vorhergehenden Ansprüche, **dadurch gekennzeichnet, dass** das Abdünnen durch Polieren oder Läppen erfolgt.

7. Verfahren zum Abdünnen eines auf ein Substrat (14) aufgesetzten Blocks (10, 12) nach einem beliebigen der vorhergehenden Ansprüche, **dadurch gekennzeichnet, dass** das Abdünnen derart eingestellt ist, dass sich eine weitestgehend konstante Geschwindigkeit des Abdünnens des aufgesetzten Blocks ergibt und N + M Minuten anhält, wobei N und M Zeitdauern sind, die gemäß den Beziehungen

$$N = \frac{E - \Delta}{V_{Si}}$$

$$M = \frac{\Delta + \delta}{V_{Si}}$$

berechnet werden, wobei $V_{Si}$ die Geschwindigkeit des Abdünnens des aufgesetzten Blocks ist, E die von dem aufgesetzten Block abzutragende Dicke ist, $\Delta$ eine vorgegebene Dicke ist, die weitaus geringer ist als E, und $\delta$ eine Dicke ist, die weitaus geringer ist als $\Delta$.

8. Verfahren zum Abdünnen eines auf ein Substrat (14) aufgesetzten Blocks (10, 12) nach einem beliebigen der vorhergehenden Ansprüche, **dadurch gekennzeichnet, dass** die Blockierschicht (16) ebenfalls auf die obere Fläche des aufgesetzten Blocks aufgetragen ist und dass es ferner das Entfernen des Abschnitts der auf die obere Fläche des aufgesetzten Blocks aufgetragenen Blockierschicht vor dem Auslösen des Abdünnens des aufgesetzten Blocks umfasst.

**9.** Verfahren zum Abdünnen eines auf ein Substrat (14) aufgesetzten Blocks (10, 12) nach einem beliebigen der vorhergehenden Ansprüche, **dadurch gekennzeichnet, dass** ein Vergießen des aufgesetzten Blocks vor dem Auftragen der Blockierschicht (16) erfolgt.

**10.** Verfahren zum Abdünnen eines auf ein Substrat (14) aufgesetzten Blocks (10, 12) nach einem beliebigen der vorhergehenden Ansprüche, **dadurch gekennzeichnet, dass** der aufgesetzte Block zu einer Matrix von auf das Substrat aufgesetzten Blöcken gehört, wobei die Blockierschicht zumindest zwischen die Blöcke der Matrix aufgetragen wird und wobei das Abdünnen bei allen Blöcken der Matrix gemeinsam erfolgt.

**Fig. 1**

**Fig. 2**

**Fig. 3**

**Fig. 4**

Fig. 5

Fig. 6

Fig. 7

Fig. 8

Fig. 9

Fig. 10

Fig. 11

Fig. 12

Fig. 13

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5264395 A
- WO 2006054005 A